Europäisches Patentamt

(19) European Patent Office

Office européen des brevets

(11) **EP 0 746 067 A1**

## (12) EUROPEAN PATENT APPLICATION

(43) Date of publication:
04.12.1996 Bulletin 1996/49

(51) Int. Cl.⁶: **H01S 3/103**, G11B 7/125, H04B 10/20

(21) Application number: 96303669.4

(22) Date of filing: 23.05.1996

(84) Designated Contracting States:
DE FR GB

(30) Priority: 03.06.1995 GB 9511248

(71) Applicant: SHARP KABUSHIKI KAISHA
Osaka 545 (JP)

(72) Inventors:
• May, Paul
Dullingham, CB8 9UH (GB)

• Walsh, Kathryn
Reading, Berkshire, RG4 5HG (GB)

(74) Representative: Robinson, John Stuart
MARKS & CLERK,
Alpha Tower,
Suffolk Street Queensway
Birmingham, B1 1TT (GB)

### (54) Variable coherence light source

(57) A variable coherence light source (2) comprises a semiconductor GRINSCH laser diode having a "p" contact segmented into regions (4, 6, 8). The shorter region (6) acts as a control region such that the laser operates in a continuous mode when the control region is forward biased and in a self pulsating mode when the control region is reverse biased. Operation in the self pulsating mode causes the coherence of the light to be reduced compared to operation in a continuous mode. Such a light source is suitable for use in optical storage systems and communications systems.

FIG 1

## Description

The present invention relates to a variable coherence light source. Such a light source is suitable for use in optical data recording/retrieval systems and optical communications networks.

Semiconductor laser diodes provide robust, compact, efficient light sources which are relatively inexpensive, easy to control and relatively efficient. However, different applications may place different demands on the light source. Some applications require greater optical power than others, and similarly some applications require high coherence whereas other applications require low coherence.

High coherence is indicated by a narrow spectral line width and is required in long distance telecommunications systems, coherent telecommunication systems and frequency standards work. Low coherence is indicated by a broad spectral line width and is helpful in reducing the effects of optical feedback from elements illuminated by the laser. This can be of great benefit in, for example, optical disc memory devices.

A laser source for a writable and readable optical disc must be able to achieve a relatively high output power to make recording of data relatively easy. To achieve this, the front facet of the laser medium is provided with a low reflection film and the rear facet of the laser is provided with a highly reflecting film. The optical disc also reflects light during operation and some of the reflected light returns to the laser gain medium. This effectively generates further laser cavities between the disc and the facets of the laser medium. This gives rise to reflected light induced noise within the laser output. This can give rise to errors when reading data from the disc.

It is known that such feedback from the disc surface (or indeed any other element illuminated by the laser) can be reduced if the coherence length of the laser is reduced.

Techniques for increasing the coherence of semiconductor lasers include the use of a periodic grating to provide feedback to the laser. The grating may be integrated with the laser, for example, in distributed feedback (DFB) and distributed Bragg reflector (DBR) lasers. Techniques for decreasing coherence include inducing pulsation of the lasers with a high frequency modulation current or the use of self pulsating structures.

EP-B-0 222 554 discloses a V-groove substrate, inner stripe (VSIS) laser diode and a method of driving the laser diode so as to vary the coherence thereof. The laser diode has three electrodes formed in series along the length of the laser cavity. The laser gain regions are controlled by the electrodes at each end of the laser cavity; whereas the central electrode is used to control a control region, i.e. a saturable absorber region. The range of operation of such a device is limited. The device fails to operate at low injection currents into the control region because of high absorption within the laser. At high injection currents the self oscillation ceases because the saturable absorber does not fully recover within the cycle of self oscillation. The patent describes that the control region and the gain regions are always forward biased and that the ratio of the current $I_g$ injected into the control region of length $L_g$ to the total current $I_t$ supplied to the laser having an active region of length $L_t$ satisfies the following relationship:

$$0.01 < \frac{I_g}{I_t} < \frac{2L_g}{3L_t}$$

The patent describes that laser operation cannot be sustained when $I_g/I_t$ is less than 0.01.

The inventors of the device described in EP-B-0222554 had not appreciated that the limit for control current within the saturable absorber region is strongly dependent upon the material used and the laser structure. In particular, quantum well lasers typically have significantly smaller optical confinement factors than bulk active region lasers, such as the VSIS type described in EP-B-0222554. The optical confinement factor is the ratio of an optical field which propagates within the active region of the device to the total optical field propagating within the active region and cladding of the device. A laser with a relatively high optical confinement factor will cease to operate with smaller increases in absorption within its control section (i.e. the saturable absorber region) when compared with a laser having a relatively low optical confinement factor. Quantum well lasers offer many advantages over bulk active region lasers, particularly lower lasing thresholds and higher efficiencies.

According to a first aspect of the present invention, there is provided a variable coherence light source, comprising a semiconductor laser having at least first and second semiconductor regions, first biasing means for biasing the first semiconductor region with a first bias of a first polarity and second biasing means for selectively biasing the second semiconductor region with a second bias variable between the first bias to produce light having a first coherence length, and a near zero bias or a bias of a second polarity opposite to the first polarity to produce light having a second coherence length less than the first coherence length.

It is thus possible to provide an electrically controllable variable coherence light source. The coherence of the light produced can be controlled without the need to supply a high frequency drive signal to the laser.

The device may have two semiconductor regions provided with a respective electrical connection. Preferably the laser has three semiconductor regions, each one of which is provided with a respective electrical connection. Thus the bias applied to each section can be controlled so as to provide control over output power and coherence of the light produced by the laser.

Advantageously the second bias provided to the laser can be used to switch the mode of operation between a continuous output and a pulsating output.

The pulsating output may be provided by mode locked operation of the laser, thereby giving rise to a relatively rapid repetition rate - typically greater than 10 GHz. Alternatively the pulsation may arise from a relaxation based self pulsation, which typically occurs at a lower frequency than mode locking - around 1 GHz or so.

Advantageously the laser has an optical confinement factor of less than 0.1. Preferably the optical confinement factor is less than 0.05.

Advantageously the laser is not a VSIS laser of the type described in EP-B-0222554. Preferably the laser is a quantum well laser, such as a quantum well graded-index separate confinement heterostructure (GRIN-SCH) ridge waveguide laser. A quantum well is a semiconductor active region, typically less than 20 nm thick, sandwiched between two layers of larger bandgap semiconductor material. The GRINSCH laser structure exhibits a low lasing threshold, high quantum efficiency and relatively high power output. The laser structure is described in a paper "High-Power Ridge Waveguide AlGaAs GRIN-SCH Laser Diode", C. Harder, P. Buchmann and H. Meier, Electronics letters Vol. 22, No.20, 1081-1082, 1986, which is incorporated herein by reference. This laser structure exhibits strong self pulsation when a section of the laser material is reverse biased - that is, for example, when a section of a segmented "p" contact of the laser is negatively biased with respect to the n contact. Quantum well GRINSCH lasers have a low optical confinement factor and so the increase in lasing threshold with increased reverse bias is much less than in the VSIS structure described in EP-B-0222554. Lasing can be sustained at reverse biases exceeding one volt.

Preferably the second semiconductor region functions as a saturable absorber. In a laser having three or more semiconductor regions, the saturable absorber may be positioned intermediate the first and third regions of semiconductor. The first and third regions are arranged to act as gain regions.

Preferably the first biasing means is arranged to forward bias the first semiconductor region. The first biasing means may also provide the bias for the third semiconductor region when a third region is provided. The first basing means may be arranged to provide an adjustable bias.

The second bias may be continuously variable between the first bias provided by the first biasing means and a second bias value which may be substantially a near zero bias or a reverse bias. As used herein "near zero bias" includes a zero bias or a condition in which the current supplied to the second semiconductor region constitutes less than one percent of the total current supplied to the semiconductor laser diode when the second bias has the same polarity as the first bias.

Either or both of the first and second biasing means may be responsive to the other biasing means such that an adjustment to coherence length by virtue of a change of the bias to the second semiconductor region need not cause a significant change in time averaged output power. Similarly if the bias provided by the first biasing means is varied to adjust the time averaged output power of the laser, the second biasing means may vary in response so as to maintain the coherence of the light. The first and second biasing means are arranged to provide substantially direct current (DC) biases.

A third biasing means may be provided to bias the third semiconductor region independently of the first semiconductor region.

The biasing means may be voltage sources, either semiconductor based or provided from a power supply via one or more series resistors or one or more potential dividers or a combination of the above. As a further alternative, the biasing means may be current sources.

According to a second aspect of the present invention, there is provided a method of controlling a semiconductor laser having at least first and second semiconductor regions, comprising biasing the first semiconductor region with a first bias of a first polarity and biasing the second semiconductor region with a second bias which is variable between the first bias to produce light having a first coherence length and a near zero bias or a bias of a second polarity opposite to the first polarity to produce light having a second coherence length less than the first coherence length.

The ability to vary the power and coherence of the laser through changing the DC biases provides a flexible device which can be adjusted in situ to operate in different modes where different levels of coherence are required. Alternatively or additionally, it can be adjusted to operate in one particular mode but in changing environments where the level of coherence and power may need to be varied depending on environment.

The present invention will further be described, by way of example, with reference to the accompanying drawings, in which:

Figure 1 is a schematic plan view of a three contact GRINSCH laser diode ;

Figure 2 is a schematic cross-section of the laser diode along the line A-A in Figure 1;

Figure 3 is a table illustrating how output power and coherence vary with polarity and magnitude of V1 and V2 for the laser illustrated in Figure 1;

Figure 4 is a graph showing fringe visibility versus path difference for a laser of the type shown in Figure 1 when the central region thereof is reverse biased giving rise to a low coherence output;

Figure 5 is a graph showing fringe visibility versus path difference for a laser of the type shown in Figure 1 when the central region thereof is forward biased to give the same current density as in the gain sections to provide a high coherence output;

Figures 6a and 6b schematically illustrate the operation of an optical disc storage device using a light source constituting an embodiment of the present invention;

Figure 7 is a schematic illustration of a local area network including a light source of the present invention; and

Figure 8 is a diagram of the interface between each computer and the fibre loop in the network of Figure 7.

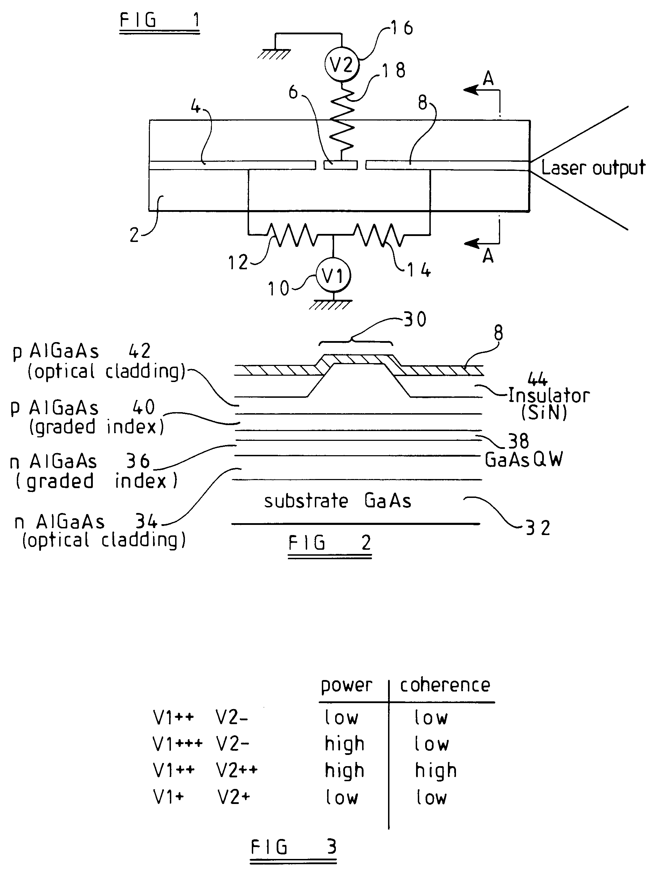

The laser diode shown in Figures 1 and 2 is a ridge structure, single quantum well (SQW), separate confinement heterostructure GaAs/AlGaAs laser 2 similar to that reported by C. Harder et al (*supra*), but with the single p contact subdivided into first, second and third contacts 4, 6 and 8, respectively, for biasing first, second and third semiconductor regions, respectively. The first and third contacts 4 and 8 are connected to a first voltage source 10 via respective resistors 12 and 14. The first voltage source provides a variable forward bias to the first and third semiconductor regions. The resistors 12 and 14 may be omitted. The second contact 6 is connected to a second voltage source 16 via a second resistor 18. The second voltage source is a variable voltage source and can bias the second semiconductor region in both the forward and reverse directions.

The ridge 30 (Figure 2) has a width of approximately 5μm, which results in the laser 2 having a single transverse mode output. The length of the laser is approximately 500μm and the length of the second contact 6 (and hence the second semiconductor region) is approximately 50μm.

The second semiconductor region functions as a saturable absorber. Too short a saturable absorber will not give rise to adequate modulation of the laser, whereas too long a saturable absorber causes excessive losses within the laser, and thereby reduces laser efficiency.

The first, second and third contacts 4, 6, and 8 are separated from each other by gaps of approximately 10μm. This gives rise to electrical isolation of around 1kΩ between adjacent contacts.

In a single contact laser, the upper contact (which has been replaced by the first, second and third contacts 4, 6, and 8) is generally known as the "p" contact. The laser has a GaAs substrate 32 which has an electrical contact connected thereto (not shown). The connection to the substrate is conventionally known as the "n" contact. An n-doped layer of AlGaAs is formed over the substrate 32 and acts as a first optical cladding layer 34. An n-doped AlGaAs graded index layer 36 is formed over the cladding layer 34. A GaAs quantum well layer 38 is formed above the graded index layer 36 and is covered by a p-doped AlGaAs graded index layer 40. The layers 36 and 40 define upper and lower regions of a waveguide surrounding the layer 38 which constitutes the active region of the laser. A p-doped AlGaAs optical cladding layer 42 is formed over the graded index layer 40. The thickness of the cladding layer 42 is profiled such that it defines the ridge 30 and the ridge portion of the layer 42 reaches through a silicon nitride insulating layer 44 to make contact with the segmented "p" contact, i.e. with the first, second and third contacts 4, 6, and 8 depending on longitudinal position along the laser.

The output power and coherence length of the laser 2 are functions of the biases V1 and V2 applied to the contacts 4 and 8, and the second contact 6, respectively. Figure 3 schematically illustrates in tabular form the relationship between power, coherence and the biases. The first and third contacts 4 and 8 are always provided with a forward bias V1. The second contact, which defines the saturable absorber, can be forward biased or reverse biased. The application of a reverse bias to the second electrode 6 can have two effects. The first is to raise the threshold current for the laser and slightly reduce the internal quantum efficiency due to absorption in the second semiconductor region. The second is to cause the laser to operate in a self pulsating mode through saturable absorption within the second semiconductor region.

The self pulsating mode may be either a first self-pulsating mode which is a mode-locked mode, giving rise to repetition rates of approximately 10GHz, or a second self pulsating mode related to relaxation effects at a repetition rate of around 1GHz. This latter regime is more typical but the self pulsating mode is a function both of device geometry and of bias so it may be possible to switch between the first and second self pulsating modes.

A forward bias on the second electrode 6 causes the lasing threshold to be reduced and an increased bias also causes the laser to switch from the self pulsating mode to a continuous output mode.

The pulsation leads to an increased spectral width and therefore lower coherence.

In Figure 3, the "+" signs indicate forward bias and the "-" signs indicate negative bias. The number of signs schematically indicates the magnitude of the bias, so "+++" is a larger forward bias than "++".

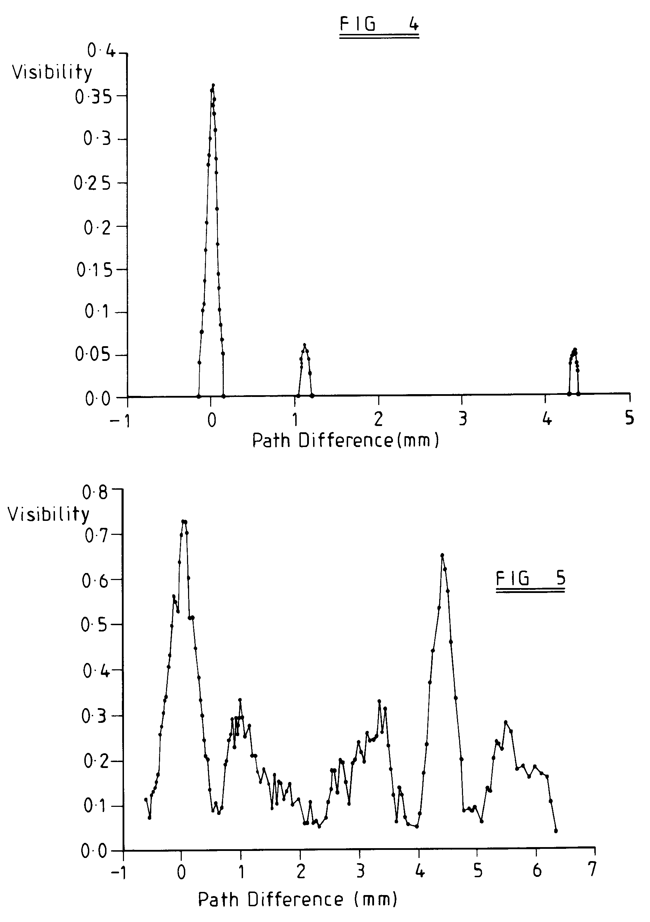

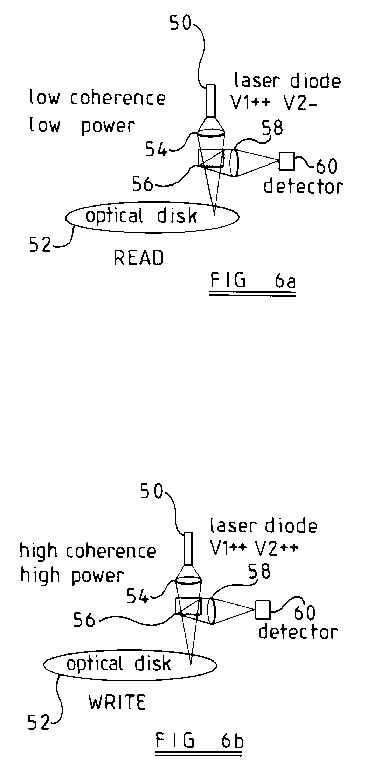

Figures 4 and 5 show the variation of coherence (fringe visibility) for a low coherence source and a high coherence source, respectively. In each case the light was produced by the laser shown in Figure 1 and the bias supplied to the first and third contacts was unaltered. The second contact 6 was reverse biased to generate the coherence pattern illustrated in Figure 4 and forward biased (to give the same current density in each region of the laser) to generate the coherence pattern shown in Figure 5.

Figures 6a and 6b schematically illustrate an optical disc storage system including a laser light source constituting an embodiment of the present invention. A laser source 50 of the type illustrated in Figure 1 is arranged to illuminate the surface of a writable optical medium such as a writable optical disc 52 via a focusing system, such as a lens 54, and a beam splitter 56. Light reflected from the surface of the disc 52 is collected via the beam splitter 56 and a lens 58 and is directed towards a detector 60.

If the second contact 6 is forward biased to give rise to the same injection current density in the second semiconductor region as in the first and third semiconductor regions, the laser behaves like a single contact laser and typically has a low lasing threshold ($< 200A/cm^2$), high internal quantum efficiency ($> 0.5$), a relatively high output power ($> 40mW$ for 100 mA injection current) and single transverse, single longitudinal mode operation. The coherence of the light produced by the laser is relatively high having a coherence length of a few millimetres. This situation corresponds to the write mode illustrated in Figure 6b where power is important and coherence is unimportant.

When a reverse bias of approximately -1V is applied to the second electrode 6, the laser pulsates at a frequency of about 1GHz, the lasing threshold becomes increased and the internal quantum efficiency is decreased. The pulsation causes the optical spectrum of the output of the laser to become chirped and the laser to operate simultaneously in a multiplicity of modes. This leads to a reduction in coherence (i.e. a coherence length of less than 0.5 mm). The time averaged output power is also reduced. For the same injection current of 100 mA into the laser gain regions as described hereinbefore, the time averaged optical output power becomes reduced to less than 10mW. This low power, low coherence mode is suited to the reading of optical discs, as illustrated in Figure 6a. The low coherence length reduces the chances of reflected light from the disc acting as a noise source within the laser gain medium.

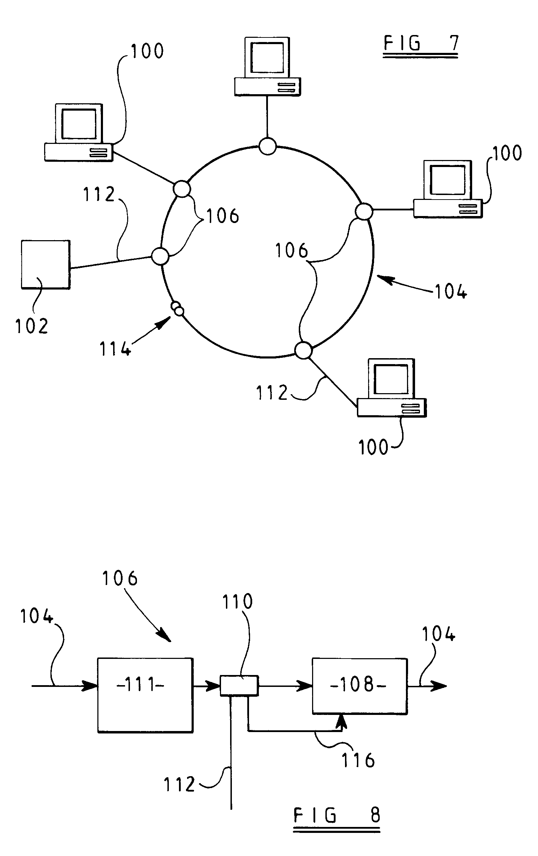

The laser of the type shown in Figure 1 can also be used to improve the performance of a local area network. Figure 7 shows such a network which consists of a number of computers 100 and peripherals, such as printer 102 (only one shown), interconnected via a multimode optical fibre loop 104. Associated with each computer 100 or peripheral device 102 is an active interface 106. Each interface 106 comprises a variable coherence laser 108, for example of the type shown in Fig 1, an electrical signal regenerator or repeater 110, and an optical receiver 111 in the form of a photodiode. The respective computer 100 or peripheral device 102 is connected with the electrical repeater 110 via line 112. The optical fibre loop 104 also has a number of couplers 114 (only one shown) to allow for additional devices to be added into the network. The interfaces 106 and any couplers 114 in the optical fibre loop 104 give rise to mode-dependent optical losses. The bit error rate is dependent on the received power level, and increases as the power level drops. The bit error rate for a given time-averaged power level is reduced if the laser is operated in a self-pulsating mode, as disclosed by R. S. J. Bates, "Multimode Waveguide Computer Data Links Self-Pulsating Laser Diodes", Int. Topical Meeting Optical Computing, Kobe, pages 89-90, Japan, 1990. Line 116 (Fig 8) is provided between repeater 110 and laser 108 to enable coherence variation (bit error rate adjustment). The reduction in bit-error rate is a function of the losses occuring at the interfaces 106 and couplers 114 within the network.

Switching the laser 108 to operate in a self-pulsating mode causes a drop in average output power (unless the injection currents to the gain region are increased) and consequently there is a trade-off between power and coherence.

The optimum compromise is specific to the characteristics of the local area network and may change as the network is re-configured. In the network shown in Fig 7, the optimum condition may be actively maintained as the number and type of devices on the network is modified. A device on the network can be used to generate a test signal. This test signal is propagated around the loop 104 and then monitored back at the same device. The coherence and power of the laser diode 108 associated therewith can then be modified by the interface 106 via the line 116 to minimise the bit error rate between the generated and received test signal. This procedure may be carried out at regular intervals to monitor and adjust for changing conditions on the network.

Although the system illustrated in Fig 7 is a ring-type local area network, other configurations can be employed, for example a star-type local area network. The electrical signal regenerator or repeater 110 may not be needed at each interface 106.

The laser structure described with reference to Figure 1 has an n-type substrate. A p-type substrate laser can be constructed with a suitable change in dopant types and reversal of the biases applied to the contacts 4, 6 and 8.

It is thus possible to provide a laser light source having adjustable power and coherence.

## Claims

1. A variable coherence light source, comprising a semiconductor laser having at least first and second semiconductor regions, first biasing means (10) for biasing the first semiconductor region with a first bias of a first polarity and second biasing means (16) for selectively biasing the second semiconductor region with a second bias variable between the first bias to produce light having a first coherence length, and a near zero bias or a bias of a second polarity opposite to the first polarity to produce light having a second coherence length less than the first coherence length.

2. A light source as claimed in Claim 1, further comprising a third semiconductor region and biasing means (10) for biasing the third semiconductor with the first polarity.

3. A light source as claimed in Claim 2, in which the second semiconductor region is optically disposed intermediate the first and third semiconductor regions.

4. A light source as claimed in any one of the preceding claims, in which the second semiconductor region functions as a saturable absorber when biased with the second polarity, and in which the or each other semiconductor region functions as a laser gain medium.

5. A light source as claimed in any one of the preceding claims, in which the second semiconductor region constitutes less than half the length of the semiconductor laser.

6. A light source as claimed in any one of the preceding claims in which the second biasing means (16) is arranged to provide a substantially continuously adjustable bias.

7. A light source as claimed in any one of the preceding claims, in which the first biasing means (10) is arranged to supply a variable bias to the first semiconductor region so as to control the output power of the light source.

8. A light source as claimed in Claim 7 when dependent on Claim 2, in which the bias supplied to the third semiconductor region is variable so as to control the output power of the light source.

9. A light source as claimed in Claim 2 or any one of claims 3 to 8 when dependent on Claim 2, in which the first biasing means (10) supplies the bias to the third semiconductor region.

10. A light source as claimed in any one of the preceding claims, in which the first biasing means (10) is responsive to an output of the second biasing means (16) so as to adjust the first bias in response to changes of the second bias so as to hold the output power substantially constant with respect to variations in the coherence length.

11. A light source as claimed in any one of the preceding claims, in which the second biasing means (16) is responsive to an output of the first biasing means (10) so as to adjust the second bias in response to changes of the first bias so as to hold the coherence length substantially constant with respect to variations in output power.

12. A light source as claimed in any one of the preceding claims, in which the first and second biasing means (10 and 16) cooperate to selectively operate the light source in a high power mode having a reduced coherence length.

13. A light source as claimed in any one of the preceding claims in which the semiconductor laser is controllable between a continuous mode and a mode locked pulsating mode.

14. A light source as claimed in any one of the preceding claims, in which the semiconductor laser is controllable between a continuous mode and a self pulsating mode.

15. A light source as claimed in any one of the preceding claims, in which the semiconductor laser is a quantum well laser.

16. A light source as claimed in any one of the preceding claims, in which the semiconductor laser is a GRINSCH laser diode.

17. An optical read/write head comprising a light source (50), focusing means (54) which focuses light from said light source (50), in use, onto an optical recording medium (52), and a detector (60) which detects light reflected, in use, from said optical recording medium (52), characterised in that said light source (50) is a light source as claimed in any one of the preceding claims.

18. A local area network comprising a plurality of networked devices (100, 102), a multimode waveguide (104), and an interface (106) associated with each device (100,102), each said interface (106) including a respective light source (108), characterised in that said light source (108) is a light source as claimed in any one of Claims 1 to 16.

19. A method of controlling the operation of a semiconductor laser having at least first and second semiconductor regions, comprising biasing the first semiconductor region with a first bias of a first polarity and biasing the second semiconductor region with a second bias which is variable between the first bias to produce light having a first coherence length and a near zero bias or a bias of a second polarity opposite to the first polarity to produce light having a second coherence length less than the first coherence length.

FIG 1

V2 ~16
~18
A
6
4
8
Laser output
2
A
12
V1
10
14

~30
8

p AlGaAs 42
(optical cladding)
44
Insulator
(SiN)
p AlGaAs 40
(graded index)
38
n AlGaAs 36
(graded index)
GaAs QW

substrate GaAs
n AlGaAs 34
(optical cladding)
32

FIG 2

|  | power | coherence |
|---|---|---|
| V1++  V2− | low | low |
| V1+++  V2− | high | low |
| V1++  V2++ | high | high |
| V1+  V2+ | low | low |

FIG 3

FIG 4

FIG 5

50

low coherence
low power

laser diode
V1++ V2-

58

54

56

60
detector

optical disk

52

READ

FIG 6a

50

high coherence
high power

laser diode
V1++ V2++

58

54

56

60
detector

optical disk

52

WRITE

FIG 6b

FIG 7

FIG 8

**European Patent Office**

# EUROPEAN SEARCH REPORT

Application Number

EP 96 30 3669

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | ECOC 83 - 9TH EUROPEAN CONFERENCE ON OPTICAL COMMUNICATION, 1983, NORTH-HOLLAND, pages 431-434, XP002012776 T. KAMIYA ET AL.: "MULTI-ELECTRODE SEMICONDUCTOR LASERS FOR COHERENCE LENGTH CONTROL" * the whole document * | 1 | H01S3/103 G11B7/125 H04B10/20 |
| Y | | 2-5, 12-19 | |
| Y | PATENT ABSTRACTS OF JAPAN vol. 13, no. 439 (E-827) [3787] , 3 October 1989 & JP-A-01 168086 (FUJITSU LTD), 3 July 1989, * abstract * | 2,3,19 | |
| A | | 1,6-9 | |
| Y | EP-A-0 417 989 (AMERICAN TELEPHONE AND TELEGRAPH COMPANY) 20 March 1991 * page 3, line 33 - page 4, line 16; figures 1,5-8 * | 5,12,15, 16 | |
| A | | 1-3,6-9, 18,19 | TECHNICAL FIELDS SEARCHED (Int.Cl.6) H01S |
| Y | JOURNAL OF LIGHTWAVE TECHNOLOGY, vol. 10, no. 4, April 1992, NEW YORK US, pages 448-457, XP000272904 M. JINNO ET AL.: "NONLINEAR OPERATIONS OF 1.55-MICROMETER WAVELENGTH MULTIELECTRODE DISTRIBUTED-FEEDBACK LASER DIODES AND THEIR APPLICATIONS FOR OPTICAL SIGNAL PROCESSING" * the whole document * | 4,13 | |
| A | | 1-3,14, 17-19 | |

-/--

The present search report has been drawn up for all claims

| Place of search | Date of completion of the search | Examiner |
|---|---|---|
| THE HAGUE | 6 September 1996 | Horak, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

**EUROPEAN SEARCH REPORT**

Application Number

EP 96 30 3669

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y,D | SPIE - CONFERENCE RECORD OF THE 1990 INTERNATIONAL TOPICAL MEETING ON OPTICAL COMPUTING, vol. 1359, 8 April 1990, KOBE, JAPAN, pages 89-90, XP002012777 R.J.S. BATES: "MULTIMODE WAVEGUIDE COMPUTER DATA LINKS WITH SELF-PULSATING LASER DIODES" * the whole document * | 14,18 | |
| A | | 1,19 | |
| Y | APPLIED PHYSICS LETTERS, vol. 56, no. 15, 9 April 1990, NEW YORK US, pages 1501-1503, XP000149822 R.N. NOTTENBURG ET AL.: "DYNAMIC OPTOELECTRONIC READ/WRITE MEMORY" * the whole document * | 17 | |
| A | | 1-4,15, 18,19 | |
| A | ELECTRONICS LETTERS, vol. 28, no. 13, 18 June 1992, STEVENAGE GB, pages 1257-1258, XP000318586 I.H. WHITE ET AL.: "LINE NARROWED PICOSECOND OPTICAL PULSE GENERATION USING THREE CONTACT INGAASP/INP MULTIQUANTUM WELL DISTRIBUTED FEEDBACK LASER UNDER GAIN SWITCHING" * the whole document * | 1-3,6-8, 13-15,19 | TECHNICAL FIELDS SEARCHED (Int.Cl.6) |
| A,D | EP-A-0 222 554 (SHARP KABUSHIKI KAISHA) 20 May 1987 * page 7, line 2 - page 12, line 17; figures 1,3,8 * | 1-9,19 | |

The present search report has been drawn up for all claims

| Place of search | Date of completion of the search | Examiner |
|---|---|---|
| THE HAGUE | 6 September 1996 | Horak, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)